(19) Europäisches Patentamt
European Patent Office
Office européen des brevets

(11) EP 4 746 289 A1

(12) EUROPEAN PATENT APPLICATION

(43) Date of publication:
20.05.2026 Bulletin 2026/21

(21) Application number: 25215978.5

(22) Date of filing: 14.11.2025

(51) International Patent Classification (IPC):
H03F 1/56 (2006.01)     H03F 3/195 (2006.01)
H03F 3/24 (2006.01)     H03F 3/62 (2006.01)
H03F 1/30 (2006.01)

(52) Cooperative Patent Classification (CPC):
H03F 1/565; H03F 3/195; H03F 3/245; H03F 3/62;
H03F 1/301; H03F 2200/294; H03F 2200/447;
H03F 2200/474

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 16.11.2024  US 202463721456 P

(71) Applicant: Space Exploration Technologies Corp.
Hawthorne, California 90250 (US)

(72) Inventors:
• AGAH, Amir
  Hawthorne, 90250 (US)
• PEPIN, Eric
  Hawthorne, 90250 (US)

(74) Representative: Mewburn Ellis LLP
Aurora Building
Counterslip
Bristol BS1 6BX (GB)

(54) TEMPERATURE CONTROLLED PHASE COMPENSATION FOR TUNED AMPLIFIERS

(57) A temperature controlled phase compensation circuit may include a varactor coupled between a radio frequency (RF) transmission line and a node. A temperature controlled phase compensation circuit may include a resistance coupled between a voltage supply and the node, the voltage supply configured to supply a supply voltage. A temperature controlled phase compensation circuit may include a temperature controlled current source coupled to the node and configured to produce a capacitor voltage between the varactor and the resistance, wherein a capacitor voltage produced at the node and applied to the varactor is inversely related to temperature.

FIG. 1

EP 4 746 289 A1

**Description**

CROSS-REFERENCE TO RELATED APPLICATIONS

The present application claims the benefit of, and priority to, U.S. Provisional Patent Application No. 63/721,456, filed November 16, 2024, entitled "TEMPERATURE CONTROLLED PHASE COMPENSATION FOR TUNED AMPLIFIERS".

TECHNICAL FIELD

The present disclosure pertains to phased array antennas for satellite communication systems and, more particularly, systems and methods for providing temperature controlled phase compensation for tuned amplifiers.

BACKGROUND

An antenna (such as a dipole antenna) typically generates radiation in a pattern that has a preferred direction. For example, the generated radiation pattern is stronger in some directions, i.e., the main lobes, and weaker in other directions, i.e., the side lobes. Likewise, when receiving electromagnetic signals, the antenna has the same preferred direction. Signal quality (e.g., signal to noise ratio or SNR), whether in transmitting or receiving scenarios, can be improved by aligning the preferred direction of the antenna with a direction of the target or source of the signal. A phased array antenna can be composed of an array of antenna elements, each having an electronically controlled phase and amplitude. An advantage of a phased array antenna is its ability to transmit and/or receive signals in a preferred direction (e.g., the antenna's beamforming ability) by adjusting each antenna element's phase delay and amplitude to "direct" the resulting transmitted or received wavefront.

Phased array antennas and, more specifically for transmitting, each antenna element in the array, must be fed one or more radio frequency (RF) signals, or beams, to be emitted; each beam being derived from a common digital signal. Similarly, when receiving, the beams received at each antenna element in the array must be routed and combined to reconstruct one or more received digital signals. As phased arrays increase in size, i.e., number of elements and scale, the distribution and combination network for the RF signals tends to degrade the RF signals as they propagate further and through more components. Such degradation may be compounded when the phased array is exposed to large temperature fluctuations.

It would be advantageous to configure phased array antennas with larger arrays and with improved phase and/or gain stability over temperature. Accordingly, embodiments of the present disclosure are directed to these and other improvements in phased array antennas or portions thereof.

SUMMARY

In some examples, systems and techniques are described for providing temperature controlled phase compensation for tuned amplifiers.

In some aspects, the techniques described herein relate to a temperature controlled phase compensation circuit, including: a varactor coupled between a radio frequency (RF) transmission line and a node; a resistance coupled between a voltage supply and the node, the voltage supply configured to supply a supply voltage; and a temperature controlled current source coupled to the node and configured to produce a capacitor voltage between the varactor and the resistance; wherein a capacitor voltage produced at the node and applied to the varactor is inversely related to temperature.

In some aspects, the techniques described herein relate to a phased array antenna system, including: a radio frequency (RF) transmission line having a first end and a second end; a first component electrically coupled to the RF transmission line at the first end or the second end, wherein the first component exhibits a capacitance reduction as a function of a reduction in a temperature at which the phased array antenna system operates; and a temperature controlled phase compensation circuit, including: a varactor coupled between the RF transmission line and a node; a resistance coupled between a voltage supply and the node, the voltage supply configured to supply a supply voltage; and a temperature controlled current source coupled to the node and configured to produce a capacitor voltage at the node in response to a change in the temperature; wherein the capacitor voltage produced at the node and applied to the varactor is CTAT, and wherein a capacitance compensation applied to the RF transmission line is CTAT and compensates for at least the capacitance reduction of the first component.

In some aspects, the techniques described herein relate to a temperature controlled phase compensation circuit, including: a varactor coupled between a radio frequency (RF) transmission line and a node; an inductor coupled between the RF transmission line and a voltage reference; and a temperature controlled voltage source coupled to the varactor at the node and configured to apply a capacitor voltage to the varactor that varies inversely with temperature.

In some aspects, the techniques described herein relate to an apparatus for providing temperature controlled phase compensation for a tuned amplifier, the apparatus including: an amplifier; an inductive load coupled to an output node of the amplifier; a varactor, wherein the varactor is alternating current (AC)-coupled to the output node of the amplifier; and a temperature controlled circuit for adjusting a direct current (DC) voltage across the varactor, wherein the temperature controlled circuit is configured to vary a capacitance of the varactor inversely to changes in temperature of the temperature controlled circuit.

In some aspects, the techniques described herein relate to a temperature controlled phase compensation circuit, including: a varactor coupled between an amplifier output node and a bias node; a resistance coupled between a voltage supply and the bias node, the voltage supply configured to supply a supply voltage; and a temperature controlled current source coupled to the bias node and configured to produce a capacitor voltage at the bias node, wherein the capacitor voltage produced at the bias node and applied to the varactor is inversely related to temperature.

This summary is not intended to identify key or essential features of the claimed subject matter, nor is it intended to be used in isolation to determine the scope of the claimed subject matter. The subject matter should be understood by reference to appropriate portions of the entire specification of this patent, any or all drawings, and each claim.

The foregoing, together with other features and aspects, will become more apparent upon referring to the following specification, claims, and accompanying drawings.

DESCRIPTION OF THE DRAWINGS

The foregoing aspects and many of the attendant advantages of this invention will become more readily appreciated as the same become better understood by reference to the following detailed description, when taken in conjunction with the accompanying drawings, wherein:

FIG. 1 is a block diagram of a portion of an example phased array antenna system in accordance with some examples of the present disclosure;

FIG. 2 is a top view of an example antenna lattice in accordance with some examples of the present disclosure;

FIG. 3 is a functional block diagram of an example front end module in accordance with some examples of the present disclosure;

FIG. 4A is a schematic diagram of a simplified example of a signal conditioning circuit in accordance with some examples of the present disclosure;

FIG. 4B is a schematic diagram of another simplified example of a signal conditioning circuit in accordance with some examples of the present disclosure;

FIG. 4C is a plot illustrating the phase performance of the amplifier of FIG. 4B over varying temperatures in accordance with some examples of the present disclosure;

FIG. 4D is a plot illustrating the phase performance of the temperature controlled phase compensation circuit of FIG. 4B over varying temperatures in accordance with some examples of the present disclosure;

FIG. 5 is a schematic diagram of an example embodiment of a temperature controlled phase compensation circuit in accordance with some examples of the present disclosure;

FIG. 6 is a graph including plots of capacitor voltage and capacitance value versus temperature for a temperature controlled phase compensation circuit in accordance with some examples of the present disclosure; and

FIG. 7 is a graph including plots of capacitor voltage and capacitance value versus temperature for a temperature controlled phase compensation circuit with varying resistance values in accordance with some examples of the present disclosure.

DETAILED DESCRIPTION

Embodiments of the disclosed apparatuses and methods relate to phased array antenna systems utilizing serial distribution of RF signals to and from the antenna elements, and circuits for applying temperature controlled phase compensation to the serially distributed RF signals. Examples of the devices, systems, and/or methods of various embodiments are provided below. An embodiment of the devices, systems, and/or methods can include any one or more, and any combination of, the examples described below.

References in the specification to "one embodiment," "an embodiment," "an illustrative embodiment," "an example," etc., indicate that the embodiment described may include a particular feature, structure, or characteristic, but every embodiment may or may not necessarily include that particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. Additionally, it should be appreciated that items included in a list in the form of "at least one A, B, and C" means at least one of (A), at least one of (B), and at least one of (C). Conversely, items listed in the form of "at least one of A, B, or C" can mean (A); (B); (C); (A and B); (B and C); (A and C); or (A, B, and C).

Language such as "top surface", "bottom surface", "vertical", "horizontal", and "lateral" in the present disclosure is meant to provide orientation for the reader with reference to the drawings and is not intended to be the required orientation of the components or to impart orientation limitations into the claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, it may not be included or may be combined with other features.

In a phased array antenna, each antenna element is driven by a dedicated radio frequency (RF) transmitter, or transmit circuit, and/or a dedicated RF receiver, or receive circuit. The "RF transmitter" and "RF receiver" are generally used herein to refer to the end-to-end assembly of components operating between a digital system, i.e., a modem, and an antenna, or antenna element, for the transmit path and the receive path, respectively, including, for example and without limitation, digital baseband beamforming components, RF waveform generators/receivers, and analog beamforming components. In some implementations, all such components are packaged together in a beamformer chip. In the disclosed phased array antenna systems, digital baseband beamforming components and RF waveform generators/receivers are packaged together for one or more given antenna elements in a digital beamformer (DBF). The DBF communicates with a modem, for example, to exchange digital data for transmitting and receiving. When transmitting, the DBF's digital baseband beamforming components construct one or more phase encoded beams to carry the digital data. The DBF's RF waveform generator components convert the one or more phase encoded beams from digital to analog, up-convert to RF, and amplify for transmission by the array of antenna elements. When receiving, the DBF's RF waveform receiver components amplify beams received by the array of antenna elements, down-convert to baseband, and digitize analog signals (e.g., convert from analog to digital). The digital beams are then recombined, phase decoded, and digitally filtered before communicating the received digital data to the modem.

In the disclosed phased array antenna systems, the DBF is paired with at least one "front end module" (FEM), generally incorporating analog beamforming components. The FEM could be a distinct FEM device, or chip, driving one or more antenna elements; or the FEM could be a component grouping within a DBF device, or chip, in which the RF transmitter and/or RF receiver are packaged. A DBF package, or a DBF and FEM pair, may include numerous RF transmitters and/or RF receivers for corresponding antenna elements. Alternatively, each DBF and FEM could be packaged independently for a single antenna element.

When transmitting, each antenna element in the phased array transmits an RF signal with a respective desired phase and amplitude to emit a desired directional beam. In some cases, a desired phase and amplitude are achieved by applying a particular phase shift and/or gain at the FEM for each antenna element. In certain embodiments, the particular phase shift and/or gain to be applied can be based on an instruction from the DBF or other controller. The phase shifts and gains can be selected for each antenna element to produce constructive interference in a transmit direction (e.g., a beam steering direction). One or more RF signals can be distributed to each FEM from a DBF. In phased array antennas having a large number of antenna elements, there may be numerous DBFs, each driving a network of FEMs, and each FEM driving one or more antenna elements. Accordingly, a baseband digital signal is distributed to each DBF, conditioned, and/or up converted to RF or IF, and then distributed to each FEM.

When receiving, the phased array is configured to receive from a particular beam steering direction. The FEM for each antenna element applies desired phase shifts and/or gains to produce constructive interference of signals received over the air from the particular beam steering direction (e.g., a receive direction). Each antenna element in the phased array receives the same over the air RF signal at a different position on the array, generally resulting in a different phase and amplitude of the received RF signals at different antenna elements depending on a transmission location of the over the air RF signal, the relative position of the transmitter and the receiving phased array, and the position of the antenna element in the antenna lattice of the phased array. The desired phase shift and/or gain associated with the particular beam steering direction can be applied at the respective FEMs for each antenna element. In certain embodiments, the particular phase shift and/or gain to be applied can be based on an instruction from a DBF or other controller. In certain embodiments, by carefully applying gain and/or phase shifts to the received signals from the antenna elements, the received signals from different antenna elements can interfere constructively for signals received from the beam steering direction. The phase shifted and/or gain adjusted received RF signals are then routed to the DBF for recombination and/or down-conversion to a baseband or IF signal. As described above, in phased array antennas having a large number of antenna elements, there may be numerous DBFs, each receiving RF signals from a network of FEMs, and each FEM receiving from one or more antenna elements. Accordingly, the received RF signal is routed through each FEM to a corresponding DBF.

Beams for transmission may be distributed serially by a DBF over a serial distribution channel to each FEM in a given FEM series, or "daisy chain." Each FEM distributes each beam to each of its corresponding antenna elements. Similarly, beams received over the air are routed from each antenna element to its corresponding FEM, and then routed serially through each FEM in a given FEM series to its corresponding DBF. The distribution and routing of beams through each FEM introduces potential power losses and compounds phase and amplitude drift as RF signals propagate through the series. For example, small amounts of phase and amplitude drift as a result of temperature change accumulate as an RF signal propagates from one end of the FEM series to the opposite end. Consequently, unless compensated for, significant differences in phase and amplitude may be exhibited between, for example, a first FEM in a series and a last FEM in the series.

Certain components in the serial distribution of RF signals are inherently sensitive to temperature drift. For example, amplifiers generally exhibit amplitude shifts and phase shifts due to parasitic capacitance changes as temperatures vary. Transmission lines can also exhibit phase and amplitude shift with temperature as their effective length changes. Such temperature drift can result in phase and/or amplitude errors in the eventual transmitted or received signal. The disclosed temperature controlled phase compensation circuit applies a variable capacitance to an output signal to compensate for parasitic capacitance reduction due to operating temperatures.

When transmitting, for example, an RF signal serially distributed to a plurality of FEMs may be buffered, i.e., amplified, at an input transmission line before being distributed to corresponding antenna elements, and buffered at an output transmission line before being fed through to a next FEM. The buffers, e.g., differential amplifiers, exhibit a parasitic capacitance that can vary with temperature, which can manifest as amplitude drift and phase drift in the amplified signal. The disclosed temperature controlled phase compensation circuit has a complimentary, or inverse, temperature response, increasing the capacitance applied to the output as temperature decreases, and reducing the capacitance applied as temperature increases. Accordingly, as parasitic capacitance drifts lower with temperature, the disclosed temperature controlled phase compensation circuit increases its capacitance compensation, resulting in level signal amplitude and consistent phase from a first FEM in a series to a last FEM in the series. Moreover, parameters of the disclosed temperature controlled phase compensation circuit enable tuning the capacitance compensation to desired levels at certain temperatures. For example, adjustments to current sources and resistance values in the disclosed temperature controlled phase compensation circuit will shift the capacitance compensation up or down for a given temperature.

The disclosed temperature controlled phase compensation circuit includes a temperature controlled current source driving a resistance to produce a voltage division between the resistance and voltage controlled capacitors, or varactors, coupled to an RF transmission line, for example, a differential transmission line or a single ended transmission line. The temperature controlled current source may include, for example, a proportional to absolute temperature (PTAT) current source. In such embodiments, as temperature declines the current output from the PTAT current source declines with it. As current declines, the voltage drop across the resistance declines, and the voltage applied to the varactors increases, thereby increasing the capacitance compensation applied to the differential lines. Conversely, as temperature increases, the current output from the PTAT current source increases, the voltage drop across the resistance increases, and the voltage applied to the varactors decreases, thereby decreasing the capacitance compensation. Accordingly, greater capacitance compensation is applied at lower temperatures, and less capacitance compensation is applied at higher temperatures, i.e., where temperature drift is less pronounced.

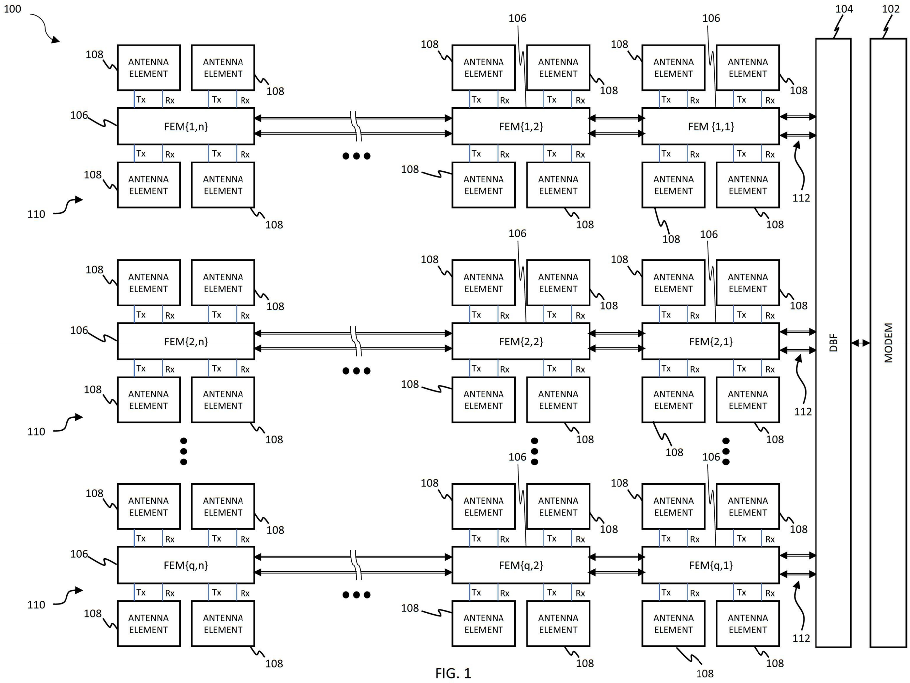

FIG. 1 is a block diagram of an example phased array antenna system 100 in accordance with some embodiments of the present disclosure. Phased array antenna system 100, also referred to as a node, communication device, device, and/or the like, is a component of a larger communications system. In some embodiments, phased array antenna system 100 is included in a wireless communications system, a wideband communications system, a satellite-based communications system, a terrestrial-based communications system, a non-geostationary (NGO) satellite communications system, a low Earth orbit (LEO) satellite communications system, and/or the like. For example, without limitation, phased array antenna system 100 can comprise a satellite, a user terminal associated with user device(s), a gateway, a repeater, or other device capable of receiving and transmitting signals with another device of a satellite communications system.

Phased array antenna system 100 includes a modem 102, a digital beamformer (DBF) chip (referred to herein as DBF 104), a plurality of FEMs 106, and a plurality of antenna elements 108. Modem 102 electrically couples to one or more DBFs, such as, for example, DBF 104. DBF 104 electrically couples with a number, q, of corresponding series, or "daisy chains," of the plurality of FEMs 106. Each of the q daisy chains of FEMs 106 is referred to herein as an FEM series 110. Each FEM series 110 electrically couples serially with a number, n, of FEMs 106. Each DBF chip electrically coupled with modem 102 is similarly configured and associated with respective series of FEMs 106. DBF 104 may also be referred to as a DBF chip, a transmit/receive (Tx/Rx) DBF chip, a Tx/Rx chip, a transceiver, a DBF transceiver, and/or the like.

Each FEM 106 of the q FEM series 110 electrically couples with a respective subset of the plurality of antenna elements 108, e.g., M antenna elements 108. A same subset of antenna elements can be used for transmit and receive signal paths within phased array antenna system 100. As an example, without limitation, DBF 104 supports q FEM series 110, each supporting up to 4 FEMs 106 (e.g., n=4) and up to 16 antenna elements (M=16) of the plurality of antenna elements 108. Alternatively, DBF 104 may support more or fewer antenna elements without departing from the scope of the present disclosure.

The phased array antenna system 100 includes a number, L, of DBFs 104. Each of the plurality of DBFs 104 may be electrically coupled to another in a daisy chain arrangement, i.e., the $i$th DBF of the plurality of DBFs 104 is electrically coupled with the ($i$th+$1$) DBF. For example, DBF 104 may be electrically coupled between modem 102 and a second DBF (not shown), and the second DBF may be electrically coupled between the second DBF and a third DBF, and so on.

DBF 104 includes an IC chip or IC chip package including a plurality of pins, in which at least a first subset of the plurality of pins is configured to communicate signals with its electrically coupled DBF chip(s) (and/or modem 102). A second subset of the plurality of pins of DBF 104 is configured to receive, for example, an LO signal (or reference clock signal) from a distribution network (not shown). The LO signal is generated by an LO (not shown). In certain embodiments, the LO is an integrated circuit (IC) chip. In some embodiments, the LO is included within an IC chip with one or more additional components, e.g., DBF 104. The LO signal is distributed to or within DBF 104 and, more specifically, to mixers within DBF 104 to facilitate performance of synchronized frequency up-conversion to radio frequency (RF) signals to be transmitted and/or down-conversion of received RF signals. The LO may include, for example and without limitation, a transmit phase-locked loop (Tx PLL), a receive phase-locked loop (Rx PLL), a multiplexer (MUX) for selecting between transmit and receiver, and/or a power amplifier (PA).

A third subset of the plurality of pins on the IC package of DBF 104 is configured to transmit or receive RF signals with FEMs 106 and antenna elements 108. DBF 104, for example, includes a plurality of RF input/output (RFIO) channels 112. Each FEM series 110 is electrically coupled with one or more RFIO channels 112. Each FEM series 110 includes one or more, or n, serially fed FEMs 106. For example, a first FEM series 110 includes a first FEM 106, a second FEM 106, and so on up to an nth FEM 106. Each FEM 106 illustrated in FIG. 1 is annotated with a {row, column} designation, where the "row" designation indicates which FEM series 110 for DBF 104 a given FEM 106 is in (e.g., 1 to q), and the "column" designation indicates where in that FEM series 110 the given FEM is positioned (e.g., 1 to n). For example, FEM {2, 1} is an FEM 106 in a second FEM series and a first FEM 106 in that FEM series 110. Likewise, FEM {q, n} is an FEM 106 in a qth FEM series and an nth FEM 106 in that FEM series 110.

RFIO channels 112, when transmitting, are configured to feed an RF signal to their respective FEM series 110. The RF signal is the result of frequency up-conversion performed within DBF 104 and is formed based on a transmit LO signal, i.e., the RF signal for transmission has a phase and frequency that is a function of the phase and frequency of the transmit LO signal. The RF signal is distributed to each FEM series 110 over an equal length signal path to minimize phase shift differences between signals arriving at the inputs of, for example, a first and second FEM series 110, which may result in phase errors in the RF signals provided to corresponding antenna elements 108 that emit the RF signals. Each FEM 106 may perform additional analog beamforming including, for example, phase shifting and/or amplification, before feeding each antenna element 108.

Referring again to the embodiment shown in FIG. 1, each of RFIO channels 112, when receiving, is configured to receive an RF signal from one of FEM series 110. The RF signal is received over the air at antenna elements 108 for each of the FEM series 110. Each FEM 106 may perform analog beamforming on the received RF signal, including, for example, phase shifting and/or amplification. In certain embodiments, each FEM 106 may also perform down-conversion to baseband or an IF. The RF (or IF or baseband) signals are then combined and propagated through the respective FEM series toward DBF 104 at RFIO channel 112. DBF 104, upon receipt of the RF signal, performs frequency down-conversion to a baseband or IF for further signal processing including, for example, analog to digital conversion.

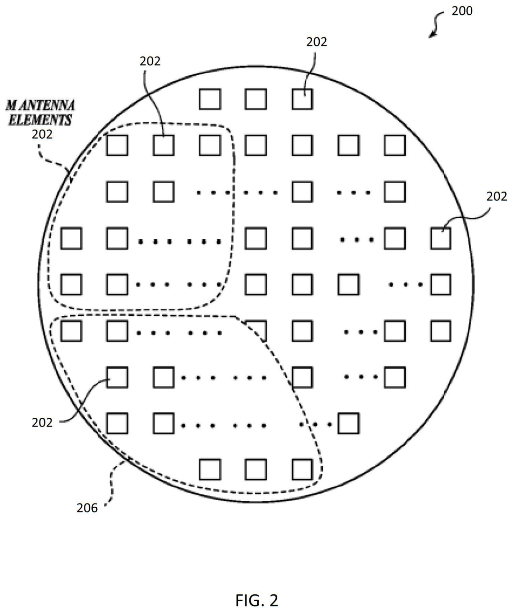

FIG. 2 is an example illustration of a top view of an antenna lattice 200 in accordance with some embodiments of the present disclosure. Antenna lattice 200 may be used, for example, in phased array antenna system 100 and, more specifically, for the plurality of antenna elements 108 shown in FIG. 1. Antenna lattice 200 includes a plurality of antenna elements 202 arranged in a particular pattern to define a particular antenna aperture. The antenna aperture is the area through which power is radiated by or to the plurality of antenna elements 202. Antenna lattice 200 defines a phased array antenna. A phased array antenna synthesizes a specified electric field (phase and amplitude) across an aperture.

Referring to FIGS. 1 and 2, a subset 206 of the plurality of antenna elements 202 shown in FIG. 2 can form the M antenna elements 108 corresponding to a particular DBF 104. The remaining subsets of antenna elements of the plurality of antenna elements 202 may be similarly associated with other DBFs.

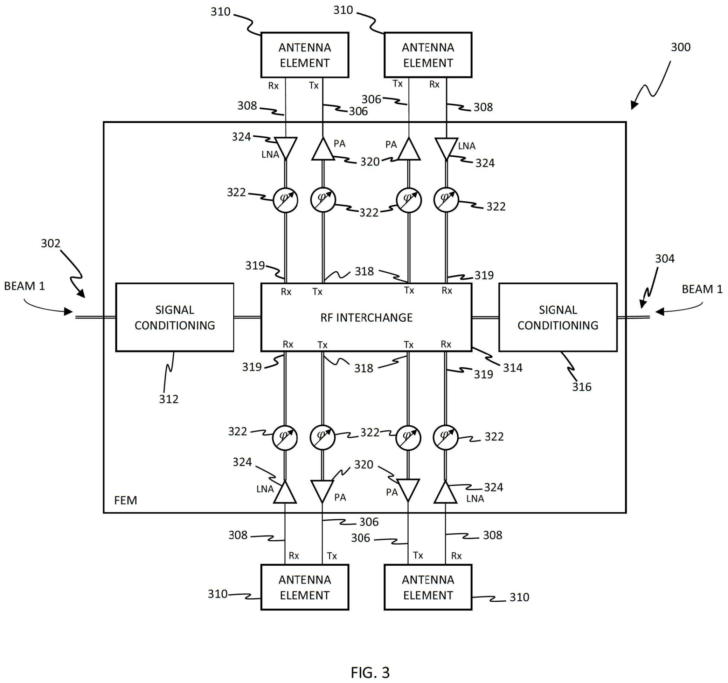

FIG. 3 is a functional block diagram of an example FEM 300 for use in a phased array antenna system, such as phased array antenna system 100 shown in FIG. 1. For example, FEM 300 may be included in a serially fed chain of FEMs, such as FEM series 110 shown in FIG. 1. FEM 300 can assume any position within such a series, e.g., FEM 300 can be a first FEM in a serially fed chain, a last FEM in a serially fed chain, or FEM 300 can be any position in between. FEM 300 can be similar to and perform similar functions to FEM 106 shown in FIG. 1. FEM 300 transmits and receives RF signals, or beams, on the serially fed chain via an RF serial port 302 and an RF serial port 304, which electrically couple FEM 300 with a prior or subsequent FEM in the series, or, e.g., a DBF such as DBF 104 shown in FIG. 1. Similarly, FEM 300 includes transmit (Tx) ports 306 and receive (Rx) ports 308 through which beams are communicated to and from a plurality of antenna elements 310. The plurality of antenna elements 310 can be similar to and perform similar functions to the plurality of antenna elements 108 shown in FIG. 1 or antenna elements 202 shown in FIG. 2.

RF serial port 302 and RF serial port 304 of FEM 300 compose opposing ends of an RF serial channel through FEM 300 that further includes a signal conditioning stage 312, an RF interchange 314, and another signal conditioning stage 316. The RF serial channel extends between RF serial port 302 and RF serial port 304, and is configured to propagate (i) one beam for transmission from RF serial port 302 to RF serial port 304, (ii) one beam, received over the air, from RF serial port 304 to RF serial port 302, (iii) one beam from RF serial port 302 to antenna elements 310 for transmission over the air, and (iv) one beam received over the air from antenna elements 310 to RF serial port 302. In alternative embodiments, FEM 300 may include a second RF serial channel for propagating a second beam.

RF interchange 314 combines signals, in a receive (Rx) mode, received over the air at the plurality of antenna elements 310 and routed to RF interchange through combination ports 319. RF interchange 314 distributes signals, to be emitted by the plurality of antenna elements 310 in a transmit (Tx) mode, through distribution ports 318.

RF serial port 302 and RF serial port 304, and the RF serial channel extending therebetween, are illustrated in FIG. 3 employing differential transmission lines. In alternative embodiments, RF serial ports 302 and RF serial port 304, and the RF serial channel extending therebetween, are implemented with single ended transmission lines.

More specifically, referring to the differential implementation shown in FIG. 3 in the Tx mode, RF interchange 314 can distribute an RF signal, i.e., a differential signal, received at RF serial port 302 of FEM 300 and conditioned by signal conditioning stage 312, to distribution ports 318 and RF serial port 304 of FEM 300. For example, in Tx mode, the differential RF signal, or beam, may be received at RF serial port 302, propagate through signal conditioning stage 312, and enter RF interchange 314 for distribution. The signal is distributed to each of the plurality of antenna elements 310 through respective distribution ports 318. As illustrated in FIG. 3, the differential RF signal can be converted to a single-ended signal by the respective PA 320. In some implementations, differential to single-ended conversion may be performed subsequent to the respective PA 320.

The RF signals distributed for transmission over the air by each antenna element 310 can be amplified by a respective PA 320 and/or phase shifted by a respective phase shifter 322 before transmission through a respective Tx port 306 to a corresponding one of the plurality of antenna elements 310. Phase shifters 322 can apply a phase shift to the corresponding distributed signals to generate a coherently combined transmitted signal (i.e., emitted by the phased array) in a desired direction (e.g., the beam steering direction). The plurality of antenna elements 310 coupled to Tx ports 306 emit, or radiate, the amplified and/or phase adjusted RF signal.

In the Rx mode, the RF interchange 314 combines respective RF signals received at RF serial port 304 and conditioned by the signal conditioning stage 316, with signals received over the air by each of the plurality of antenna elements 310. In receive mode, an RF signal, or beam, is received over the air by antenna elements 310. The RF signals from each of the plurality of antenna elements 310 are routed through respective Rx ports 308 toward RF interchange 314 for combination with signals received through RF serial port 304, i.e., from one or more subsequent FEMs in the series. The received signal from each of the plurality of antenna elements 310 can be amplified by low noise amplifiers (LNAs) 324 and/or phase shifted by phase shifters 322. As illustrated in FIG. 3, the differential RF signal can be converted to a single-ended signal by the respective LNA 324 for each antenna element. In some implementations, differential to single-ended conversion may be performed subsequent to the respective LNA 324.

Although the Rx signal path, as illustrated in FIG. 3, includes a single LNA 324 and a single phase shifter 322 coupled to each of the plurality of antenna elements 310, in some cases, a separate phase shifter 322 and/or LNA 324 can be coupled to each of the plurality of antenna elements 310 for receiving multiple beams. Similarly, the Tx signal path, as illustrated in FIG. 3, includes a single phase shifter 322 and a single PA 320 coupled to each of the plurality of antenna elements 310. In some embodiments, a separate phase shifter 322 and/or PA 320 can be coupled to each of the plurality of antenna elements 310 for transmitting multiple beams. Likewise, signal conditioning stage 312, RF interchange 314, and signal conditioning stage 316 may be implemented with multiple differential signal paths for combining, routing, and conditioning multiple received beams, and for conditioning and distributing multiple beams for transmission.

RF interchange 314, when transmitting, splits RF signals for transmission and distributes them to distribution ports 318. When receiving, RF interchange combines RF signals for routing to RF serial port 302. Each time a beam is split or combined within RF interchange 314, the signal experiences a power loss. For example, when splitting an RF signal received at an input port to two output ports, the power is divided approximately equally, effectively exhibiting a 3 dB loss from the input port to either one output port. When combining, for example, two signals, the combined signal may exhibit a small, but non-zero, power loss. Signal conditioning stage 312 and signal conditioning stage 316, in certain example embodiments, may include components such as, for example, and without limitation, bidirectional buffers, additional LNAs, PAs, variable gain amplifiers (VGAs), transformers, differential amplifiers, and/or phase shifters (e.g., for Rx and/or Tx). In certain embodiments, signal conditioning stage 312 and signal conditioning stage 316 include active buffers to compensate for losses exhibited by, e.g., transmission lines, RF interchange 314, and for losses incurred when each beam is split or combined. Active buffers also can increase the isolation with the external environment (e.g., the rest of the PCB). FEM 300 can be configured, e.g., utilizing signal conditioning stages 312 and 316, to provide an equal gain among each of the plurality of antenna elements 310 and, furthermore, equal gain among multiple instances of FEM 300 connected in series, such as multiple instances of FEM 106 in FEM series 110, shown in FIG. 1.

Certain components in the serial distribution of RF signals, e.g., within FEM 300, are inherently sensitive to temperature drift. For example, amplifiers generally exhibit amplitude shifts (e.g., losses) and phase shifts due to parasitic capacitance changes as temperatures vary. Transmission lines can also exhibit phase and amplitude shift with temperature as their effective length changes. Such amplitude and phase shifts are referred to as temperature drift. The distribution and routing of beams through each FEM 300 in a series compounds amplitude and phase shifts incurred within each FEM. Such temperature drift can result in phase and/or amplitude errors in the eventual transmitted or received signal. The disclosed complementary to absolute temperature (CTAT) capacitance compensation circuit applies a variable capacitance to an output signal of signal conditioning stage 312 and/or signal conditioning stage 316 to compensate for parasitic capacitance reduction due to operating temperature changes.

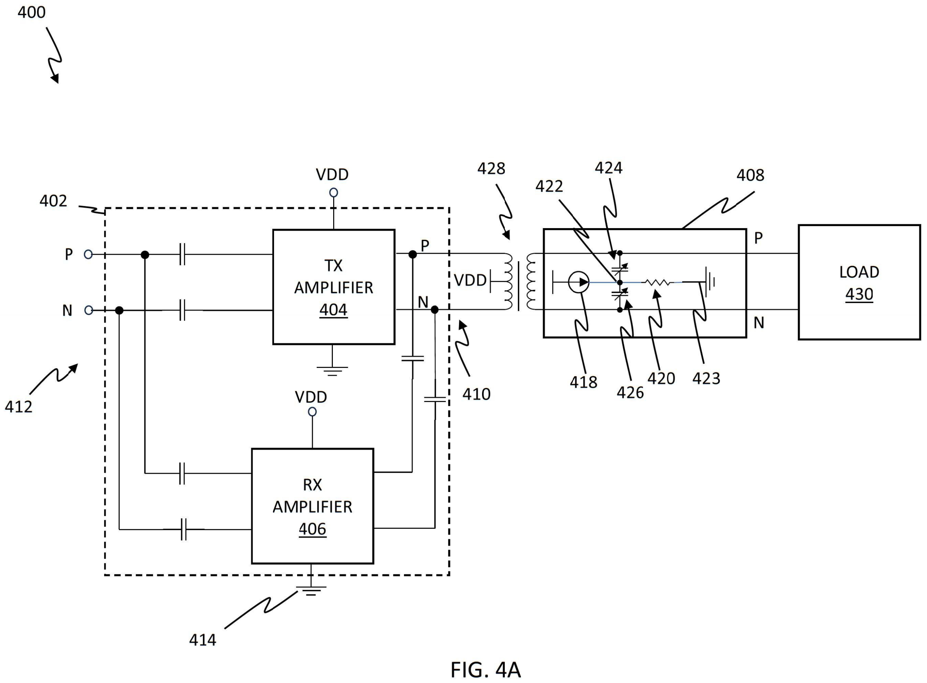

FIG. 4A is a schematic diagram of an embodiment of a signal conditioning circuit 400, in accordance with some examples of the present disclosure. Signal conditioning circuit 400 may be implemented, for example, within signal conditioning stage 312 and/or signal conditioning stage 316. Signal conditioning circuit 400 may include, for example, an RF bidirectional buffer circuit 402 having both a transmit amplifier 404 and a receive amplifier 406. Transmit amplifier 404 and receive amplifier 406 may include, for example, respective differential amplifiers, VGAs, or any other suitable active components. Signal conditioning circuit 400 includes a temperature controlled phase compensation circuit 408 coupled at an output stage 410 of transmit amplifier 404 (or an input stage of receive amplifier 406).

Signal conditioning circuit 400 includes, generally, RF bidirectional buffer circuit 402 electrically coupled between differential transmission lines. More specifically, at an input stage 412 of transmit amplifier 404 (or an output stage of receive amplifier 406), signal conditioning circuit 400 includes a positive signal line, P, and a negative signal line, N. Likewise, at output stage 410, signal conditioning circuit 400 includes a positive signal line, P, and a negative signal line, N. Notably, output stage 410 and input stage 412 are bidirectional, meaning output stage 410, when receiving, functions as an input circuit and input stage 412 functions as an output circuit. RF bidirectional buffer circuit 402 also couples to a ground 414, or GND. Output stage 410 can be AC coupled to temperature controlled phase compensation circuit 408 by a center-tapped transformer 428.

Temperature controlled phase compensation circuit 408 includes a temperature controlled current source 418 driving a resistance 420 coupled between a node 422 and a reference voltage 423. In some cases, the reference voltage 423 may be coupled to a ground potential, GND). In some implementations, the reference voltage 423 may be coupled to a constant voltage other than the ground potential. The current supplied to resistance 420 can be varied with temperature to produce a variable voltage at node 422. In one illustrative example, temperature controlled current source 418 can be configured in a CTAT configuration that produces a current that varies inversely with temperature, i.e., as temperature declines, current increases, and as temperature increases, current declines. The variable voltage produced at node 422 increases as the current through resistance 420 increases, and the variable voltage decreases as the current through resistance 420 decreases.

Temperature controlled phase compensation circuit 408 includes a voltage controlled varactor 424 and a voltage controlled varactor 426 coupled between node 422 and the output differential transmission line, i.e., the positive signal line, P, and the negative signal line, N. As the variable voltage at node 422 increases, a capacitance value of voltage controlled varactor 424 and a capacitance value of voltage controlled varactor 426 increases. The variable voltage increases with declining temperatures, thus producing an increasing capacitance that is applied to a differential output of the temperature controlled phase compensation circuit 408. As illustrated in FIG. 4A, the differential output of the temperature controlled phase compensation circuit 408 can be coupled to a load 430. In some implementations, the load 430 can be a capacitive load or an inductive load, such as a transformer, or can correspond to at least one or more of an RF interchange (e.g., RF interchange 314 of FIG. 3), signal conditioning stage 316, and/or components (e.g., LNAs, PAs, phase shifters) coupled to the distribution ports 318 and combination ports 319 of the RF interchange 314.

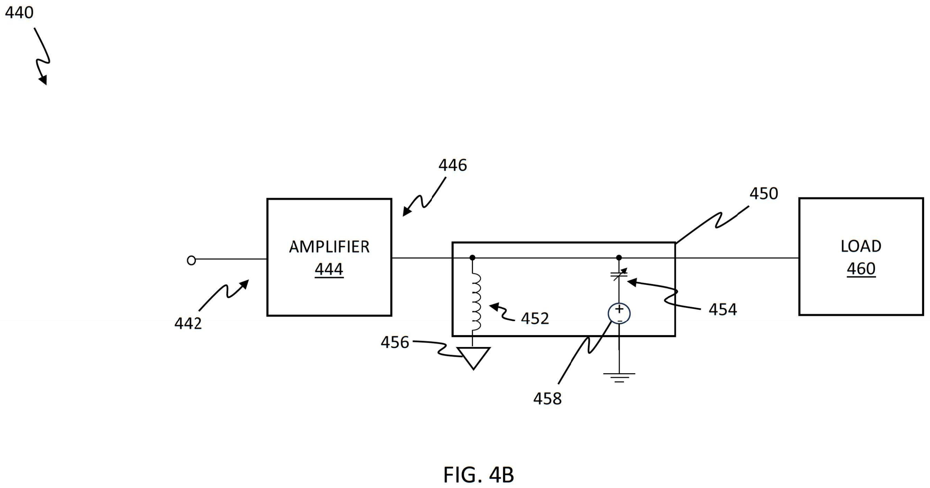

FIG. 4B is a schematic diagram of an additional simplified example of a signal conditioning circuit 440 in accordance with some examples of the present disclosure. In the example of FIG. 4B, a temperature controlled phase compensation circuit 450 is coupled to an output stage 446 of an amplifier 444, which is shown in a single ended configuration. In some cases, an input stage 442 of the amplifier 444 can obtain a signal to be transmitted by antenna elements (e.g., plurality of antenna elements 310 of FIG. 3) coupled to a FEM (e.g., FEM 300 of FIG. 3). In some cases, coupling between the output stage 446 of the amplifier 444 and the <u>temperature controlled phase compensation circuit</u> 450 can include a DC isolation circuit (not shown) to isolate the temperature controlled phase compensation circuit 450 from the DC voltage level at the output stage 446 of the amplifier 444. In some implementations, a voltage at the voltage reference 456 may act as a DC bias for the output stage 446 of the amplifier 444. Temperature controlled phase compensation circuit 450 includes an LC tuned circuit, or resonator, including an inductor 452 and a varactor 454. Inductor 452 is coupled between output stage 446 and a voltage reference 456. Varactor 454 is coupled between a voltage supply 458 and output stage 446. The voltage across varactor 454 can be the voltage difference between the voltage reference 456 and the voltage supplied by the voltage supply 458. Accordingly, the capacitance of the varactor 454 can be varied by varying a voltage output by voltage supply 458. In some cases, an output of the temperature controlled phase compensation circuit 450 can be coupled to a load 460. The load 460 can correspond to at least one or more of an RF interchange (e.g., a single ended version of RF interchange 314 of FIG. 3), a signal conditioning stage (e.g., signal conditioning stage 316 of FIG. 3), and/or components (e.g., LNAs, PAs, phase shifters) coupled to the distribution ports (e.g., distribution ports 318) and combination ports (e.g., combination ports 319) of the RF interchange.

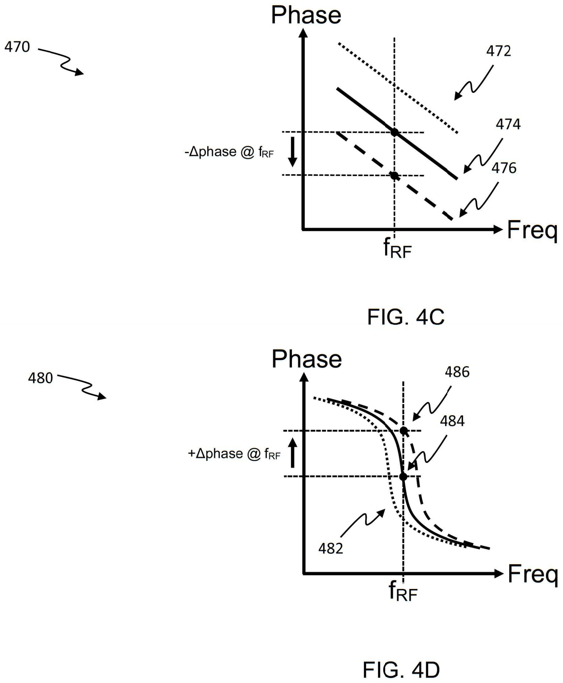

FIG. 4C and FIG. 4D are plots illustrating how varactor 454 can be used to provide phase stability for an output signal of amplifier 444 of FIG. 4B, which can be distributed to antenna elements (e.g., plurality of antenna elements 310 of FIG. 3) and to an RF serial port (e.g., RF serial port 304 of FIG. 3) of a FEM (e.g., FEM 300 of FIG. 3).

FIG. 4C is a plot 470 illustrating the phase (vertical axis) vs. frequency (horizontal axis) performance of amplifier 444 over varying temperatures. As illustrated in FIG. 4C, amplifier 444 can have a transmit frequency of $f_{RF}$ for transmitting signals. Plot 470 illustrates the phase performance of the amplifier 444 at progressively increasing temperatures with a curve 472 representing a low temperature, a curve 474 representing a middle temperature, and a curve 476 representing a high temperature for operation of the amplifier 444. As shown in FIG. 4C, the increase in temperature can result in a decrease in the phase at the transmit frequency $f_{RF}$.

FIG. 4D is a plot 480 illustrating the phase (vertical axis) vs. frequency (horizontal axis) performance of temperature controlled phase compensation circuit 450 of FIG. 4B over varying temperatures. The plot 480 illustrates the phase performance of LC tuned circuit including inductor 452 and varactor 454 as the capacitance value of varactor 454 is varied by voltage supply 458. FIG. 4D illustrates a curve 482 representing a low capacitance value, a curve 484 representing a middle capacitance value, and a curve 486 representing a high capacitance value for varactor 454. As illustrated in FIG. 4D, the phase value at the transmit frequency $f_{RF}$ can increase as the capacitance of the varactor 454 increases. As described above with respect to FIG. 4B, the capacitance value of varactor 454 of the temperature controlled phase compensation circuit 450 can be varied by varying a voltage output of the voltage supply 458. In some cases, the phase response of the LC tuned circuit can be configured to vary with temperature in such a way that temperaturerelated phase changes in the amplifier are canceled by changes in the capacitance value of the varactor 454.

It should be noted that amplifier phase errors related to temperature fluctuations in amplifiers included in a through-path (e.g., in signal conditioning stage 312 and/or signal conditioning stage 316 of FIG. 3) of an FEM series (e.g., FEM series 110 of FIG. 1) can compound at each FEM (e.g., FEM 106) of the FEM series. Accordingly, performing temperature based phase compensation to correct for amplifier phase errors related to temperature can be particularly beneficial along the through-path of an FEM series. Similarly benefits may also be found in any configuration in which amplifiers connected in series experience phase errors related to temperature fluctuations.

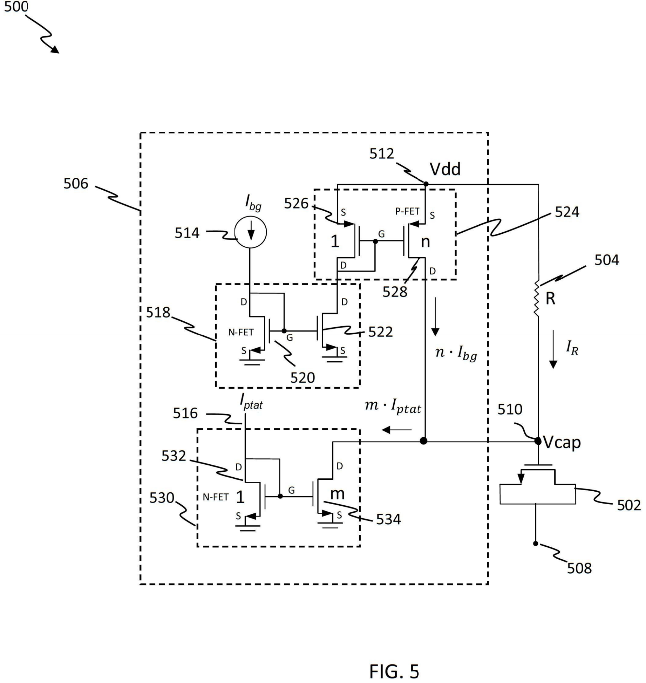

FIG. 5 is a schematic diagram of an example embodiment of a temperature controlled phase compensation circuit 500 in accordance with some examples of the present disclosure. Temperature controlled phase compensation circuit 500 is similar to and performs similar functions as temperature controlled phase compensation circuit 408 shown in FIG. 4A or temperature controlled phase compensation circuit 450 shown in FIG. 4B. In particular, temperature controlled phase compensation circuit 500 includes a varactor 502 coupled with a resistance 504 and a current source 506. Temperature controlled phase compensation circuit 500 also includes a compensation node 508 at which temperature controlled phase compensation circuit 500 is configured to be coupled, for example, to a bus, transmission line, trace, or the like. Referring to signal conditioning circuit 400 shown in FIG. 4A, for example, compensation node 508 may be coupled to positive signal line, P, or negative signal line, N, of output stage 410. Likewise, two instances of varactor 502 within temperature controlled phase compensation circuit 500 would provide two compensation nodes 508 for coupling, for example, to both positive signal line, P, and negative signal line, N, of output stage 410 for a differential implementation. In some cases, the compensation nodes 508 can have a DC voltage level at a ground potential, GND, or at a reference potential other than GND.

Resistance 504, in certain embodiments, is a resistor, R, with a resistance value selected to produce a desired capacitive compensation in varactor 502. For example, at a given temperature, higher resistance values for resistance 504 corresponds to a greater voltage drop across resistance 504 for a given current value and, therefore, a lower voltage (Vcap) applied to varactor 502. In some cases, the capacitance of varactor 502 can corresponding lower when a lower Vcap voltage is applied.

In certain embodiments, as shown in FIG. 5, varactor 502 is a metal-oxide semiconductor (MOS) capacitor having its gate electrode coupled to a node 510 at which Vcap is produced by temperature controlled phase compensation circuit 500, and having its body coupled to an output terminal, or compensation node 508, of temperature controlled phase compensation circuit 500. Compensation node 508 can be coupled to a load, such as load 430 shown in FIG. 4A or load 460 shown in FIG. 4B. The load can correspond to at least one or more of an RF interchange (e.g., a single ended version of RF interchange 314 of FIG. 3), a signal conditioning stage (e.g., signal conditioning stage 316 of FIG. 3) , and/or components (e.g., LNAs, PAs, phase shifters) coupled to the distribution ports (e.g., distribution ports 318) and combination ports (e.g., combination ports 319) of the RF interchange.

Current source 506 produces a voltage between a voltage supply, or supply voltage node 512, and node 510 that is applied to resistance 504. As shown in FIG. 5, supply voltage node 512 is also referred to as VDD, and node 510 is referred to as the capacitor voltage, Vcap. Accordingly, the capacitor voltage, Vcap, is the supply voltage, VDD, minus the voltage drop across resistance 504, Vr.

Generally, the current generated by current source 506 produces a voltage across resistance 504, Vr, that changes with temperature, i.e., Vr increases as temperature increases and Vr decreases as temperature decreases. The voltage change as a function of temperature shifts the voltage division between resistance 504 and varactor 502, thereby producing a CTAT capacitance at compensation node 508.

More specifically, current source 506 generates an output current by mirroring and combining currents from a bandgap current source 514 and a PTAT current source 516.

As shown in FIG. 5, the current mirroring can be implemented using a network of metal-oxide semiconductor field effect transistors (MOSFETs) configured as current mirror circuits. As illustrated, the current produced by PTAT current source 516, Iptat, is an input current to and is mirrored by a current mirror circuit 530. The current produced by bandgap current source 514, Ibg, is an input to a fixed ratio current mirror circuit 518, and the current output of current mirror circuit 518 is mirrored by a current mirror circuit 524. In some embodiments, the PTAT current can be based on bandgap current source 514 or another bandgap current source. For example, the PTAT current may be expressed as:

$$I_{PTAT} = I_{bg}\left(1 + \frac{T-27}{300}\right).$$

Where, T is temperature expressed in Kelvin.

Bandgap current source 514 supplies the bandgap current, Ibg, to an N-channel metal-oxide semiconductor (NMOS) based current mirror circuit 518 including an N-channel field effect transistor (N-FET) 520 and an N-FET 522. Source electrodes for N-FET 520 and N-FET 522 are coupled to ground. N-FET 520 and N-FET 522 within current mirror circuit 518 can have the same channel width-to-length ( $W/L$ ) ratio, which results in a 1:1 current mirroring from N-FET 520 to N-FET 522.

The mirrored current from current mirror circuit 518, i.e., a drain current from N-FET 522, is supplied to a P-channel metal-oxide semiconductor (PMOS) based current mirror circuit 524 including a P-channel field effect transistor (P-FET) 526 and a P-FET 528. Source electrodes for P-FET 526 and P-FET 528 are coupled to supply voltage node 512 (e.g., Vdd). P-FET 526 and P-FET 528 within current mirror circuit 524 are selected to produce a desired current gain from P-FET 526 to P-FET 528. More specifically, a channel width-to-length ratio, n, for P-FET 528 is selected relative to a channel width-to-length ratio for P-FET 526, e.g., $W/L_{in}$ , to produce the desired current gain. An output current from current mirror circuit 524, i.e., a drain current from P-FET 528, is supplied to node 510. The output current of current mirror circuit 524 can be expressed as:

$$I_{out} = \frac{W/L_{OUT}}{W/L_{IN}} I_{bg}$$

Where, $W/L_{OUT}$ is the channel width-to-length ratio, for P-FET 528, and $W/L_{IN}$ is the channel width-to-length ratio for P-FET 526. As shown in FIG. 5, for example, where the $\frac{W/L_{OUT}}{W/L_{IN}} = n$ for P-FET 526, the output current of current mirror circuit 524 is: $I_{out} = n \cdot I_{bg}$.

PTAT current source 516 supplies the PTAT current, Iptat, to an NMOS based current mirror circuit 530 including an N-FET 532 and an N-FET 534. Source electrodes for N-FET 532 and N-FET 534 are coupled to ground. N-FET 532 and N-FET 534 within current mirror circuit 530 are selected to produce a desired current gain from N-FET 532 to N-FET 534. More specifically, a channel width-to-length ratio, $W/L_{OUT,PTAT}$, for N-FET 534 is selected relative to a channel width-to-length ratio for N-FET 532, e.g., $W/L_{IN,PTAT}$, to produce the desired current gain. An output from current mirror circuit 530, i.e., a drain current from N-FET 534, can sink a current proportional to Iptat from the node 510. The current entering the drain of N-FET 534 can be expressed as:

$$I_{sink} = \frac{W/L_{OUT,PTAT}}{W/L_{IN,PTAT}} I_{PTAT}$$

Where, $W/L_{OUT,PTAT}$ is the channel width-to-length ratio for N-FET 534, and $W/L_{IN,PTAT}$ is the channel width-to-length ratio for N-FET 532. As shown in FIG. 5, for example, where the $\frac{W/L_{OUT,PTAT}}{W/L_{IN,PTAT}} = m$ for N-FET 532, the output current of current mirror circuit 530 is: $I_{sink} = m \cdot I_{PTAT}$.

The output currents of current mirror circuit 524 and current mirror circuit 530 are functions of Ibg and Iptat, respectfully. Current at node 510, where the varactor voltage, Vcap, is produced, sums to zero. Current components entering the node 510 can be the current conducted through resistance 504 and the output current of current mirror circuit 524, i.e., the drain current for P-FET 528; and the current component exiting the node 510 can be the current entering current mirror circuit 530, i.e., the drain current for N-FET 534. At DC voltage, no current flows through the varactor 502. The current at node 510 can be solved such that the net current (e.g., current in - current out) at node 510 is equal to zero:

$$n \cdot I_{bg} + I_R - m \cdot I_{PTAT} = 0$$

Solving for $I_R$ yields $I_R = m \cdot I_{PTAT} - n \cdot I_{bg}$

Given the definition above for current supplied by PTAT current source 516, the current through resistance 504 can be expressed in terms of the bandgap current, Ibg.

$$I_R = m \cdot I_{bg} \left(1 + \frac{T-27}{300}\right) - n \cdot I_{bg}$$

$$I_R = I_{bg} \left((m - n) + m \left(\frac{T-27}{300}\right)\right)$$

Given the current, $I_R$, conducted through resistance 504, the capacitor voltage, Vcap, can be computed, which controls the capacitance value of varactor 502. As explained above, the capacitor voltage, Vcap, is the supply voltage, VDD, minus the voltage drop over resistance 504, which is a function of the current, $I_R$, and resistance, R, for resistance 504, according to Ohm's Law.

$$V_{cap} = VDD - R \cdot I_R$$

$$V_{cap} = VDD - R \cdot I_{bg} \left((m - n) + m \left(\frac{T-27}{300}\right)\right)$$

Accordingly, the capacitor voltage, Vcap can behave as a CTAT voltage for the varactor 502. For a given temperature, or for several temperatures in an operating profile, the capacitor voltage is controlled as a function of the resistance value of resistance 504, the Ibg, Iptat, and the choice of MOSFET device sizes, i.e., the electrical characteristics of the devices. For example, adjusting the resistance value of resistance 504 at a constant current value $I_R$ have an inverse relationship with the capacitor voltage, Vcap. Alternatively, adjusting the scaling ratios, m and n, of the N-FET and P-FET devices in current mirror circuit 530 and current mirror circuit 524, respectively, changes the amount of current running through the resistance 504 by scaling the output current of current mirror circuit 530 and/or current mirror circuit 524. In some cases, changing the scaling ratios m and/or n can change the intercept, shape, and/or slope of the CTAT response. In one illustrative example, increasing scaling ratio m increases the slope of the temperature response. For example, increasing the width-to-length ratio, m, for N-FET 534 increases, or scales, the drain current through N-FET 534, increasing the current conducted through resistance 504 and, thereby increasing the voltage drop across resistance 504. Similarly, for example, increasing the width-to-length ratio, n, for P-FET 528 increases, or scales, the drain current through P-FET 528, which reduces the current conducted through resistance 504 and decreases the voltage drop across resistance 504.

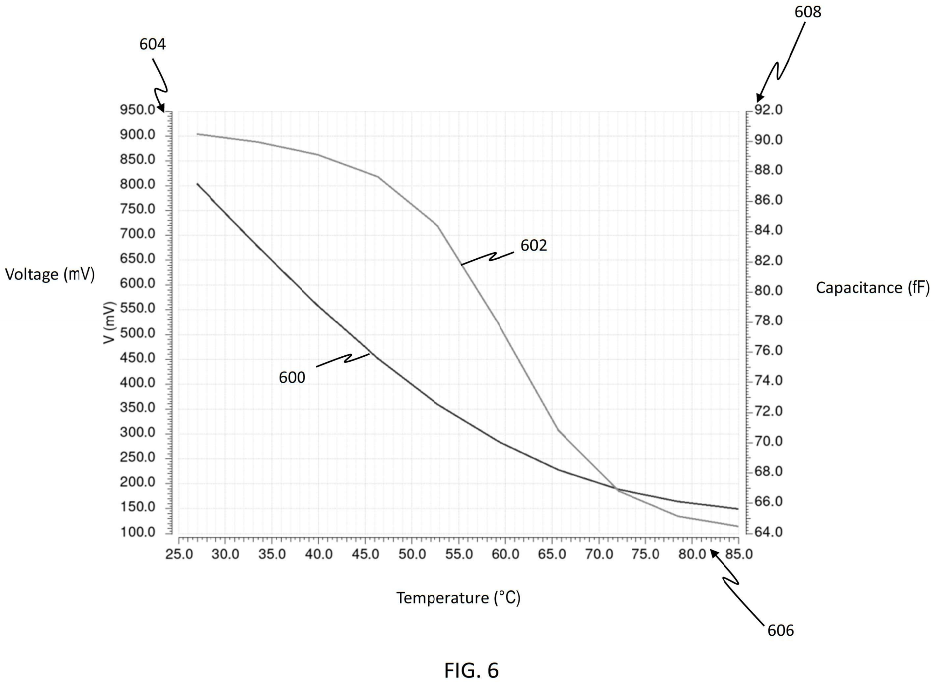

FIG. 6 is a graph including a plot 600 of capacitor voltage, Vcap, for varactor 502, shown in FIG. 5, versus temperature and a plot 602 of capacitance value of varactor 502 versus temperature. Plot 600 of capacitor voltage is shown with reference to a left vertical axis 604 representing voltage in millivolts (mV) ranging from 100 mV to 950 mV, and a horizontal axis 606 representing temperature in degrees Celsius (C) ranging from 25.0 degrees C to 85.0 degrees C. Plot 602 of capacitance value is shown with reference to a right vertical axis 608 representing capacitance in femtofarads (fF) ranging from 64.0 fF to 92.0 fF, relative to the horizontal axis 606 representing temperature.

Referring to FIG. 5 and FIG. 6, plot 600 illustrates capacitor voltage, Vcap, produced at node 510 and applied to varactor 502. Notably, capacitor voltage increases as temperature decreases, and capacitor voltage decreases as temperature increases, i.e., capacitor voltage, Vcap, is CTAT. Because varactor 502 is voltage controlled, as temperature decreases and capacitor voltage increases, plot 602 illustrates that capacitance value increases. Conversely, as temperature increases and capacitor voltage decreases, capacitance value decreases.

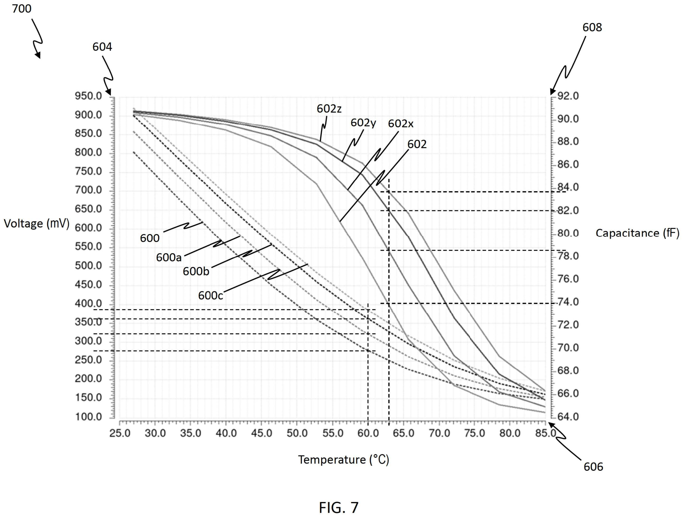

FIG. 7 is a graph 700 including plot 600 of capacitor voltage, shown in FIG. 6, as well as plots of capacitor voltage for varactor 502 versus temperature with alternative resistance values for R. FIG. 7 includes left vertical axis 604 representing voltage in mV, horizontal axis 606 representing temperature in degrees C, and right vertical axis 608 representing capacitance in fF. FIG. 7 includes plot 600, a plot 600a, a plot 600b, and a plot 600c of capacitor voltage for varactor 502 with decreasing resistance values, R, respectively, for resistance 504, shown in FIG. 5, relative to the resistance value, R, for plot 600. The resistance value for resistance 504 corresponding to plot 600a is referred to as Ra, the resistance value for resistance 504 corresponding to plot 600b is referred to as Rb, and the resistance value for resistance 504 corresponding to plot 600c is referred to as Rc. Resistance value R is greater than Ra, resistance value Ra is greater than Rb, and resistance value Rb is greater than Rc.

As shown in FIG. 7, for a given temperature, a decreasing resistance value, R, for resistance 504 results in an increasing capacitor voltage, Vcap, applied to varactor 502. For example, at 60 degrees C, resistance value R produces a capacitor voltage, Vcap, of about 275 mV, resistance value Ra produces a capacitor voltage, Vcap, of about 320 mV, resistance value Rb produces a capacitor voltage, Vcap, of about 360 mV, and resistance value Rc produces a capacitor voltage, Vcap, of about 385 mV. More generally, a decreasing resistance value, R, reduces the voltage drop across resistance 504 and increases the capacitor voltage, Vcap. Accordingly, another parameter that can have a similar effect is to adjust the current $I_R$ conducted through resistance 504 by adjusting the scaling ratios m and/or n. For example, for a given temperature, as current through the resistor $I_R$, decreases the capacitor voltage, Vcap, increases.

FIG. 7 includes plot 602 of capacitance value, shown in FIG. 6, as well as plots of capacitance value for varactor 502 versus temperature with alternative resistance values for R. More specifically, Fig. 7 includes a plot 602x, a plot 602y, and a plot 602z of capacitance value for varactor 502 with decreasing resistance values, R, for resistance 504, shown in FIG. 5, relative to the resistance value R, for plot 602. The resistance value for resistance 504 corresponding to plot 602x is referred to as Rx, the resistance value for resistance 504 corresponding to plot 602y is referred to as Ry, and the resistance value for resistance 504 corresponding to plot 602z is referred to as Rz. Resistance value R is greater than Rx, resistance value Rx is greater than Ry, and resistance value Ry is greater than Rz. As shown in FIG. 7, for a given temperature, a decreasing resistance value, R, for resistance 504 results in an increasing capacitance value for varactor 502. For example, at 63 degrees C, resistance value R produces a capacitance value for varactor 502 of about 74.0 fF, resistance value Rx produces a capacitance value for varactor 502 of about 78.6 fF, resistance value Ry produces a capacitance value for varactor 502 of about 82.0 fF, and resistance value Rz produces a capacitance value for varactor 502 of about 83.7 fF. More generally, a decreasing resistance value, R, reduces the voltage drop across resistance 504 and increases the capacitor voltage, Vcap, thereby increasing the resulting capacitance value of varactor 502. Accordingly, as explained above, increasing or decreasing the current through the resistor, $I_R$, can have a similar effect on the capacitance value of varactor 502 at a given temperature.

The following disclosure sets out certain aspects of the disclosed invention in the form of clauses corresponding to the claims. These clauses are provided to ensure explicit and literal support for the claims as filed, and for any future amendments, under the requirements of various jurisdictions. Each clause should be understood as forming part of the description and as an independent disclosure of inventive subject matter.

Clause 1. A temperature controlled phase compensation circuit, comprising: a varactor coupled between a radio frequency (RF) transmission line and a node; a resistance coupled between a voltage supply and the node, the voltage supply configured to supply a supply voltage; and a temperature controlled current source coupled to the node and configured to produce a capacitor voltage between the varactor and the resistance; wherein a capacitor voltage produced at the node and applied to the varactor is inversely related to temperature.

Clause 2. The temperature controlled phase compensation circuit of clause 1 further comprising a second varactor coupled between a second differential line of the RF transmission line and the node, wherein the varactor is a first varactor coupled between a first differential line of the RF transmission line and the node.

Clause 3. The temperature controlled phase compensation circuit of clause 1, wherein the varactor comprises a metal-oxide semiconductor (MOS) capacitor.

Clause 4. The temperature controlled phase compensation circuit of clause 1, wherein the resistance comprises a resistance.

Clause 5. The temperature controlled phase compensation circuit of clause 1, wherein the temperature controlled current source comprises a proportional to absolute temperature (PTAT) current source configured to control a voltage across the resistance.

Clause 6. The temperature controlled phase compensation circuit of clause 5, wherein the temperature controlled current source further comprises a bandgap current source configured to control the voltage across the resistance.

Clause 7. The temperature controlled phase compensation circuit of clause 6, wherein the temperature controlled current source further comprises a current mirror circuit coupled between the bandgap current source and the node, the current mirror circuit configured to supply an output current to the node, the output current proportional to a bandgap current supplied by the bandgap current source.

Clause 8. The temperature controlled phase compensation circuit of clause 7, wherein the current mirror circuit comprises: a first metal-oxide semiconductor field effect transistor (MOSFET) coupled to the bandgap current source, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 9. The temperature controlled phase compensation circuit of clause 5, wherein the temperature controlled current source further comprises a current mirror circuit coupled between the PTAT current source and the node, the current mirror circuit configured to supply an output current to the node, the output current proportional to a PTAT current supplied by the PTAT current source.

Clause 10. The temperature controlled phase compensation circuit of clause 9, wherein the current mirror circuit comprises: a first metal-oxide semiconductor field effect transistor (MOSFET) configured to conduct an input current proportional to the PTAT current, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 11. A phased array antenna system, comprising: a radio frequency (RF) transmission line having a first end and a second end; a first component electrically coupled to the RF transmission line at the first end or the second end, wherein the first component exhibits a capacitance reduction as a function of a reduction in a temperature at which the phased array antenna system operates; and a temperature controlled phase compensation circuit, comprising: a varactor coupled between the RF transmission line and a node; a resistance coupled between a voltage supply and the node, the voltage supply configured to supply a supply voltage; and a temperature controlled current source coupled to the node and configured to produce a capacitor voltage at the node in response to a change in the temperature; wherein the capacitor voltage produced at the node and applied to the varactor is CTAT, and wherein a capacitance compensation applied to the RF transmission line is CTAT and compensates for at least the capacitance reduction of the first component.

Clause 12. The phased array antenna system of clause 11, wherein the RF transmission line is a differential transmission line, wherein the varactor is a first varactor coupled between a first differential line of the RF transmission line and the node, the phased array antenna system further comprising a second varactor coupled between a second differential line of the RF transmission line and the node.

Clause 13. The phased array antenna system of clause 11, wherein the varactor comprises a metal-oxide semiconductor (MOS) capacitor.

Clause 14. The phased array antenna system of clause 11, wherein the temperature controlled current source comprises a proportional to absolute temperature (PTAT) current source configured to control a voltage across the resistance.

Clause 15. The phased array antenna system of clause 14, wherein the temperature controlled current source further comprises a bandgap current source configured to control the voltage across the resistance.

Clause 16. The phased array antenna system of clause 15, wherein the temperature controlled current source further comprises a current mirror circuit coupled between the bandgap current source and the node, the current mirror circuit configured to supply an output current to the node, the output current proportional to a bandgap current supplied by the bandgap current source.

Clause 17. The phased array antenna system of clause 16, wherein the current mirror circuit comprises: a first metal-oxide semiconductor field effect transistor (MOSFET) coupled to the bandgap current source, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 18. The phased array antenna system of clause 14, wherein the temperature controlled current source further comprises a current mirror circuit coupled between the PTAT current source and the node, the current mirror circuit configured to supply an output current to the node, the output current proportional to a PTAT current supplied by the PTAT current source.

Clause 19. The phased array antenna system of clause 18, wherein the current mirror circuit comprises: a first metal-oxide semiconductor field effect transistor (MOSFET) configured to conduct an input current proportional to the PTAT current, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 20. The phased array antenna system of clause 11, wherein the first component comprises an amplifier having an output terminal electrically coupled to the first end of the RF transmission line.

Clause 21. The phased array antenna system of clause 20, wherein the RF transmission line comprises a differential transmission line, and wherein the amplifier comprises a differential amplifier.

Clause 22. A temperature controlled phase compensation circuit, comprising: a varactor coupled between a radio frequency (RF) transmission line and a node; an inductor coupled between the RF transmission line and a voltage reference; and a temperature controlled voltage source coupled to the varactor at the node and configured to apply a capacitor voltage to the varactor that varies inversely with temperature.

Clause 23. The temperature controlled phase compensation circuit of clause 22, wherein the varactor comprises a metal-oxide semiconductor (MOS) capacitor.

Clause 24. The temperature controlled phase compensation circuit of clause 22, wherein the temperature controlled voltage source comprises: a resistance coupled between the node and a second voltage reference, and a temperature controlled current source coupled to the node and configured to shift a voltage division of the second voltage reference between the varactor and the resistance.

Clause 25. The temperature controlled phase compensation circuit of clause 24, wherein the temperature controlled current source comprises a proportional to absolute temperature (PTAT) current source configured to control a voltage across the resistance.

Clause 26. The temperature controlled phase compensation circuit of clause 25, wherein the temperature controlled current source further comprises a bandgap current source configured to control the voltage across the resistance.

Clause 27. The temperature controlled phase compensation circuit of clause 26, wherein the temperature controlled current source further comprises a current mirror circuit coupled between the bandgap current source and the node, the current mirror circuit configured to supply an output current to the node, the output current proportional to a bandgap current supplied by the bandgap current source.

Clause 28. The temperature controlled phase compensation circuit of clause 27, wherein the current mirror circuit comprises: a first metal-oxide semiconductor field effect transistor (MOSFET) coupled to the bandgap current source, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 29. The temperature controlled phase compensation circuit of clause 25, wherein the temperature controlled current source further comprises a current mirror circuit coupled between the PTAT current source and the node, the current mirror circuit configured to supply an output current to the node, the output current proportional to a PTAT current supplied by the PTAT current source.

Clause 30. The temperature controlled phase compensation circuit of clause 29, wherein the current mirror circuit comprises: a first metal-oxide semiconductor field effect transistor (MOSFET) configured to conduct an input current proportional to the PTAT current, the first MOSFET having a first channel width-to-length ratio; and a second MOSFET coupled to the node and configured to conduct the output current, the second MOSFET having a second channel width-to-length ratio; wherein the second channel width-to-length ratio divided by the first channel width-to-length ratio scales the output current supplied to the node.

Clause 31. An apparatus for providing temperature controlled phase compensation for a tuned amplifier, the apparatus comprising: an amplifier; an inductive load coupled to an output node of the amplifier; a varactor, wherein the varactor is alternating current (AC)-coupled to the output node of the amplifier; and a temperature controlled circuit for adjusting a direct current (DC) voltage across the varactor, wherein the temperature controlled circuit is configured to vary a capacitance of the varactor inversely to changes in temperature of the temperature controlled circuit.

Clause 32. The apparatus of clause 31, wherein the temperature controlled circuit comprises a temperature controlled current source configured to vary a voltage across the varactor.

Clause 33. The apparatus of clause 32, wherein the voltage across is generated by the temperature controlled current source flowing through a resistance.

Clause 34. The apparatus of clause 31, wherein the varactor is coupled between to the output node and a capacitor voltage node.

Clause 35. The apparatus of clause 34, wherein the output node is direct current (DC) biased with a fixed DC voltage and wherein the capacitor voltage node is controllable by the temperature controlled circuit, and wherein a difference between the fixed DC voltage and a voltage of the capacitor voltage node comprises a voltage across the varactor.

Clause 36. The apparatus of clause 35, wherein the temperature controlled circuit is configured to vary the voltage across the varactor inversely with temperature.

Clause 37. The apparatus of clause 36, wherein the temperature controlled circuit comprises a complementary to absolute temperature (CTAT) current source.

Clause 38. The apparatus of clause 36, wherein the temperature controlled circuit comprises a CTAT voltage source.

Clause 39. The apparatus of clause 36, wherein the temperature controlled circuit comprises a PTAT current source, and wherein an increase in a current output of the PTAT current source reduces the voltage across the varactor.

Clause 40. The apparatus of clause 31, wherein a tuned load for the amplifier comprises the inductive load and the varactor.

Clause 41. The apparatus of clause 40, wherein the inductive load comprises an inductor coupled between the output node of the amplifier and a DC reference voltage.

Clause 42. The apparatus of clause 40, wherein the inductive load comprises a first winding of a transformer, and wherein the varactor is coupled with a second winding of the transformer.

Clause 43. The apparatus of clause 40, wherein reducing a capacitance value of the varactor increases a center frequency of tuned load for the amplifier.

Clause 44. The apparatus of clause 43, wherein increasing the center frequency of the tuned load for the amplifier compensates for a temperature-based phase shift of the amplifier.

Clause 45. The apparatus of clause 31, wherein the amplifier is included in a through-path of a front-end module (FEM) of a FEM series.

Clause 46. A temperature controlled phase compensation circuit, comprising: a varactor coupled between an amplifier output node and a bias node; a resistance coupled between a voltage supply and the bias node, the voltage supply configured to supply a supply voltage; and a temperature controlled current source coupled to the bias node and configured to produce a capacitor voltage at the bias node, wherein the capacitor voltage produced at the bias node and applied to the varactor is inversely related to temperature.

The clauses above are provided for clarity of disclosure and support, and do not limit the scope of the appended claims. Features described in any one clause may be combined with features of any other clause, except where such combinations are clearly incompatible.

The term "computer-readable medium" includes, but is not limited to, portable or non-portable storage devices, optical storage devices, and various other mediums capable of storing, containing, or carrying instruction(s) and/or data. A computer-readable medium may include a non-transitory medium in which data can be stored and that does not include carrier waves and/or transitory electronic signals propagating wirelessly or over wired connections. Examples of a non-transitory medium may include, but are not limited to, a magnetic disk or tape, optical storage media such as compact disk (CD) or digital versatile disk (DVD), flash memory, memory or memory devices. A computer-readable medium may have stored thereon code and/or machine-executable instructions that may represent a procedure, a function, a subprogram, a program, a routine, a subroutine, a module, a software package, a class, or any combination of instructions, data structures, or program statements. A code segment may be coupled to another code segment or a hardware circuit by passing and/or receiving information, data, arguments, parameters, or memory contents. Information, arguments, parameters, data, etc. may be passed, forwarded, or transmitted via any suitable means including memory sharing, message passing, token passing, network transmission, or the like.

In some embodiments the computer-readable storage devices, mediums, and memories can include a cable or wireless signal containing a bit stream and the like. However, when mentioned, non-transitory computer-readable storage media expressly exclude media such as energy, carrier signals, electromagnetic waves, and signals per se.

Specific details are provided in the description above to provide a thorough understanding of the embodiments and examples provided herein. However, it will be understood by one of ordinary skill in the art that the embodiments may be practiced without these specific details. For clarity of explanation, in some instances the present technology may be presented as including individual functional blocks comprising devices, device components, steps or routines in a method embodied in software, or combinations of hardware and software. Additional components may be used other than those shown in the figures and/or described herein. For example, circuits, systems, networks, processes, and other components may be shown as components in block diagram form in order not to obscure the embodiments in unnecessary detail. In other instances, well-known circuits, processes, algorithms, structures, and techniques may be shown without unnecessary detail in order to avoid obscuring the embodiments.

Individual embodiments may be described above as a process or method which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be rearranged. A process is terminated when its operations are completed but could have additional steps not included in a figure. A process may correspond to a method, a function, a procedure, a subroutine, a subprogram, etc. When a process corresponds to a function, its termination can correspond to a return of the function to the calling function or the main function.

Processes and methods according to the above-described examples can be implemented using computer-executable instructions that are stored or otherwise available from computer-readable media. Such instructions can include, for example, instructions and data that cause or otherwise configure a general purpose computer, special purpose computer, or a processing device to perform a certain function or group of functions. Portions of computer resources used can be accessible over a network. The computer executable instructions may be, for example, binaries, intermediate format instructions such as assembly language, firmware, source code. Examples of computer-readable media that may be used to store instructions, information used, and/or information created during methods according to described examples include magnetic or optical disks, flash memory, USB devices provided with non-volatile memory, networked storage devices, and so on.

Devices implementing processes and methods according to these disclosures can include hardware, software, firmware, middleware, microcode, hardware description languages, or any combination thereof, and can take any of a variety of form factors. When implemented in software, firmware, middleware, or microcode, the program code or code segments to perform the necessary tasks (e.g., a computer-program product) may be stored in a computer-readable or machine-readable medium. A processor(s) may perform the necessary tasks. Typical examples of form factors include laptops, smart phones, mobile phones, tablet devices or other small form factor personal computers, personal digital assistants, rackmount devices, standalone devices, embedded systems, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are example means for providing the functions described in the disclosure.

Many embodiments of the technology described herein may take the form of computer- or controller-executable instructions, including routines executed by a programmable computer or controller. Those skilled in the relevant art will appreciate that the technology can be practiced on computer/controller systems other than those shown and described above. The technology can be embodied in a special-purpose computer, controller or data processor that is specifically programmed, configured or constructed to perform one or more of the computer-executable instructions described above. Accordingly, the terms "computer" and "controller" as generally used herein refer to any data processor and can include Internet appliances and hand-held devices (including palmtop computers, wearable computers, cellular or mobile phones, multi-processor systems, processor-based or programmable consumer electronics, network computers, minicomputers and the like).

Information handled by these computers can be presented at any suitable display medium, including an organic light emitting diode (OLED) display or liquid crystal display (LCD).

Although certain embodiments have been illustrated and described herein for purposes of description, a wide variety of alternate and/or equivalent embodiments or implementations calculated to achieve the same purposes may be substituted for the embodiments shown and described without departing from the scope of the present disclosure. This application is intended to cover any adaptations or variations of the embodiments discussed herein. Therefore, it is manifestly intended that embodiments described herein be limited only by the claims.

## Claims

1. A temperature controlled phase compensation circuit, comprising:

   a varactor coupled between a radio frequency (RF) transmission line and a node;
   an impedance coupled between a voltage supply and the node, the voltage supply configured to supply a supply voltage; and
   a temperature controlled current source coupled to the node and configured to produce a capacitor voltage between the varactor and the resistance;
   wherein a capacitor voltage produced at the node and applied to the varactor is inversely related to temperature.

2. The temperature controlled phase compensation circuit of claim 1, wherein the impedance comprises a resistance.

3. A temperature controlled phase compensation circuit, comprising:

   a varactor coupled between a radio frequency (RF) transmission line and a node;
   an inductor coupled between the RF transmission line and a voltage reference; and
   a temperature controlled voltage source coupled to the varactor at the node and configured to apply a capacitor voltage to the varactor that varies inversely with temperature.

4. The temperature controlled phase compensation circuit of claim 3, wherein the temperature controlled voltage source comprises:

   a impedance coupled between the node and a second voltage reference; and
   a temperature controlled current source coupled to the node and configured to shift a voltage division of the second voltage reference between the varactor and the impedance.

5. The temperature controlled phase compensation circuit of any one of claims 1-4 further comprising a second varactor coupled between a second differential line of the RF transmission line and the node, wherein the varactor is a first varactor coupled between a first differential line of the RF transmission line and the node.

6. The temperature controlled phase compensation circuit of any one of claims 1-5, wherein the varactor comprises a metal-oxide semiconductor (MOS) capacitor.

7. The temperature controlled phase compensation circuit of any one of claims 1 or 4-6, wherein the temperature controlled current source comprises a proportional to absolute temperature (PTAT) current source configured to control a voltage across the impedance.

8. The temperature controlled phase compensation circuit of claim 7, wherein the temperature controlled current source further comprises a current mirror circuit coupled between the PTAT current source and the node, the current mirror circuit configured to supply an output current to the node, the output current proportional to a PTAT current supplied by the PTAT current source.

9. The temperature controlled phase compensation circuit of any one of claims 1 or 4-8, wherein the temperature controlled current source further comprises a bandgap current source configured to control the voltage across the impedance.

10. The temperature controlled phase compensation circuit of claim 9, wherein the temperature controlled current source further comprises a current mirror circuit coupled between the bandgap current source and the node, the current mirror circuit configured to supply an output current to the node, the output current proportional to a bandgap current supplied by the bandgap current source.

11. The temperature controlled phase compensation circuit of any one of claims 8-10, wherein the current mirror circuit comprises:

a first metal-oxide semiconductor field effect transistor (MOSFET) coupled to the bandgap current source, the first MOSFET having a first channel width-to-length ratio; and
a second MOSFET coupled to the node and configured to conduct the output current, the second MOSFET having a second channel width-to-length ratio;
wherein the second channel width-to-length ratio divided by the first channel width-to-length ratio scales the output current supplied to the node.

12. A phased array antenna system including the temperature controlled phase compensation circuit of any one of the preceding claims, the phased array antenna system further comprising:

the RF transmission line having a first end and a second end; and
a first component electrically coupled to the RF transmission line at the first end or the second end, wherein the first component exhibits a capacitance reduction as a function of a reduction in a temperature at which the phased array antenna system operates.

13. The phased array antenna system of claim 12, wherein the first component comprises an amplifier having an output terminal electrically coupled to the first end of the RF transmission line.

14. The phased array antenna system of claim 13, wherein the RF transmission line comprises a differential transmission line, and wherein the amplifier comprises a differential amplifier.

FIG. 1

FIG. 2

EP 4 746 289 A1

FIG. 3

EP 4 746 289 A1

FIG. 4A

EP 4 746 289 A1

FIG. 4B

EP 4 746 289 A1

FIG. 4C

FIG. 4D

FIG. 5

EP 4 746 289 A1

FIG. 6

EP 4 746 289 A1

FIG. 7

Europäisches
Patentamt

European
Patent Office

Office européen
des brevets

# EUROPEAN SEARCH REPORT

**Application Number**

EP 25 21 5978

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/326859 A1 (ABBAS MOHAMED HELMY AHMED [US] ET AL) 24 October 2019 (2019-10-24) | 1-4,6-14 | INV. H03F1/56 H03F3/195 |
| A | * paragraphs [0039], [0043], [0051], [0078]; figures 6,7 * | 5 | H03F3/24 H03F3/62 H03F1/30 |
| X | CN 115 276 573 A (UNIV ZHEJIANG) 1 November 2022 (2022-11-01) | 1-5,7-10 | |
| A | * paragraphs [0010], [0034]; figures 1,2,4,5 * | 6,11-14 | |
| A | US 2022/140797 A1 (OSHIMA NAOKI [JP] ET AL) 5 May 2022 (2022-05-05) * paragraphs [0070] - [0072]; figure 5 * | 1-14 | |
| A | US 2024/080062 A1 (WANG CHENG-HAN [US] ET AL) 7 March 2024 (2024-03-07) * paragraphs [0056] - [0064]; figure 6 * | 1-14 | |

**TECHNICAL FIELDS SEARCHED (IPC)**

H03F

The present search report has been drawn up for all claims

| Place of search | Date of completion of the search | Examiner |
|---|---|---|
| The Hague | 26 March 2026 | Goethals, Filip |

EPO FORM 1503 03.82 (P04C01)

## ANNEX TO THE EUROPEAN SEARCH REPORT
## ON EUROPEAN PATENT APPLICATION NO.

EP 25 21 5978

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2026

| Patent document cited in search report | | Publication date | Patent family member(s) | | Publication date |
|---|---|---|---|---|---|
| US 2019326859 | A1 | 24-10-2019 | NONE | | |
| CN 115276573 | A | 01-11-2022 | NONE | | |
| US 2022140797 | A1 | 05-05-2022 | JP 7586569 B2 | | 19-11-2024 |
| | | | JP WO2020166196 A1 | | 28-10-2021 |
| | | | US 2022140797 A1 | | 05-05-2022 |
| | | | WO 2020166196 A1 | | 20-08-2020 |
| US 2024080062 | A1 | 07-03-2024 | CN 119856395 A | | 18-04-2025 |
| | | | EP 4584882 A1 | | 16-07-2025 |
| | | | US 2024080062 A1 | | 07-03-2024 |
| | | | WO 2024054748 A1 | | 14-03-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63721456